# EUROPEAN PATENT SPECIFICATION

(11) **EP 3 413 075 B1**
(45) Date of publication and mention of the grant of the patent: **02.10.2024**
(21) Application number: 17179813.5
(22) Date of filing: 05.07.2017
(51) Int. Cl.: G01R 33/567

(54) **MRI INVOLVING THE GENERATION OF A PHYSIOLOGICAL MOTION SIGNAL USING A PILOT TONE NAVIGATOR**
MRI MIT ERZEUGUNG EINES PHYSIOLOGISCHEN BEWEGUNGSSIGNALS UNTER VERWENDUNG EINES PILOTTON-NAVIGATORS
IRM IMPLIQUANT LA GÉNÉRATION D'UN SIGNAL DE MOUVEMENT PHYSIOLOGIQUE UTILISANT UN NAVIGATEUR DE TONALITÉ PILOTE

(30) Priority: 08.06.2017 DE 102017209708; 08.06.2017 DE 102017209710
(43) Date of publication of application: 12.12.2018
(73) Proprietor: Siemens Healthineers AG, 91301 Forchheim (DE)
(72) Inventor: Speier, Peter, 91056 Erlangen (DE); Bacher, Mario, 90441 Nürnberg (DE); Schmidt, Michaela, 91080 Uttenreuth (DE)
(74) Representative: Siemens Healthineers Patent Attorneys

(56) References cited:
- GRAESSLIN I ET AL: "Advancements in Contact-Free Respiration Monitoring using RF Pick-up coils", PROCEEDINGS OF THE INTERNATIONAL SOCIETY FOR MAGNETIC RESONANCE IN MEDICINE, ISMRM, 18TH SCIENTIFIC MEETING AND EXHIBITION, STOCKHOLM, SWEDEN, 1-7 MAY 2010, 17 April 2010 (2010-04-17), pages 3045, XP040614492
- PASCAL SPINCEMAILLE ET AL: "Kalman filtering for real-time navigator processing", MAGNETIC RESONANCE IN MEDICINE., vol. 60, no. 1, 1 July 2008 (2008-07-01), US, pages 158 - 168, XP055447072, ISSN: 0740-3194, DOI: 10.1002/mrm.21649
- WETZL J ET AL: "Feasibility Study: Free-Breathing 3-D CINE Imaging with Respiratory Gating Based on Pilot Tone Navigation", PROCEEDINGS OF THE INTERNATIONAL SOCIETY FOR MAGNETIC RESONANCE IN MEDICINE, ISMRM, 24TH ANNUAL MEETING AND EXHIBITION, SINGAPORE, 7-13 MAY 2016, no. 2613, 22 April 2016 (2016-04-22), pages 2613, XP040683654
- TAO ZHANG ET AL: "Robust self-navigated body MRI using dense coil arrays : Robust Self-Navigated Body MRI", MAGNETIC RESONANCE IN MEDICINE., vol. 76, no. 1, 29 July 2015 (2015-07-29), US, pages 197 - 205, XP055447076, ISSN: 0740-3194, DOI: 10.1002/mrm.25858
- BONANNO G ET AL: "Self-Gated Golden Angle Spiral CINE MRI for Endothelial Function Assessment", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HAWAII, USA, 22-27 APRIL 2017, no. 928, 7 April 2017 (2017-04-07), pages 928, XP040688496

## Description

The present invention describes a method for generating a medical data set of a moving body part, a computer program product as well as a control unit.

Magnetic Resonance (MR) imaging is slow. Therefore, it is necessary to synchronize the data acquisition with any motion that affects the final image. The most typical example for this is organ motion in the field-of-view (FOV). The most important motions for compliant patients are respiratory and cardiac motion. Cardiac motion generates pulsatile blood flow everywhere in the body. Therefore, applications that are sensitive to blood flow variations benefit or require synchronization to the cardiac motion even if the heart is far away from the FOV.

Cardiac synchronization is typically achieved by monitoring the electric activity of the heart with an ECG (Electrocardiogram) device and deriving a trigger signal at the time of the R-wave, i.e., start of left-ventricular (LV) contraction. For example documents US 8116856 B2 or US 7899521 B2 describe an arrangement for recording ECG signals and document US 7702376 B2 describes a method for ECG-triggering a measuring sequence of a magnetic resonance device. The main advantages of this approach is that the R-wave is narrow and therefore the trigger time point can be well defined and appears at the start of the heart contraction. The disadvantages of this approach are:
- The ECG sensor must be attached to the patient. This typically requires trained staff to place the electrodes after preparation of the skin of a patient with abrasive gels and in some cases shaving.
- MR gradient switching induces currents in the Electrocardiography (ECG) leads that lead to artefacts in the measured signal that need to be suppressed. There are multiple approaches to achieve this, and it is an active research field. Fact is that the problem has not been solved completely yet.
- In the strong magnetic field of the MR magnet, the ECG is superposed by another signal, generated by the hydromagneto-dynamic effect: Blood contains ions that move with varying velocity in the magnetic field. The Lorenz force leads to a partial separation of positive and negative ions, generating macroscopic time varying net currents, which in turn induce currents in the ECG leads. The effect is typically small on 1.5T-MRT-device. It increases with B0 and the surface covered by the ECG leads, so it may become a problem at higher magnetic fields, e.g. 3T and 7T.
- While in principle two electrodes are sufficient to detect an R-wave, multiple electrodes are applied to increase ECG reliability. Typically, there are 4 electrodes in use. From these, a spatial direction of electrical activity is derived (vector ECG). This direction follows a time course that depends on the electrode geometry relative to the heart, and therefore on the orientation of the patient. The time course is learned and applied as a detection filter to suppress non-ECG signals. Unfortunately, depending on the patient, the heart moves more or less with respiratory motion and therefore the time course will vary more or less with the respiratory state. This reduces reliability of the ECG during deep breathing. In some patients, the heart rate decreases after inspiration in breath-holding, leading to impaired image quality.

An innovative way for inferring information about respiratory motion or patient motion during patient acquisitions in MR measurements, termed "Pilot Tone (PT) Navigation" has been described in DE 10 2015 203 385 A1 and further in post-published document DE 10 2015 224 162 A1.

The basic principle is to measure the variation induced by physiological motion by means of a coherent and/or continuous external frequency signal received by the local coil elements outside the receive bandwidth of the actually scanned MR field of view, but within the range of the oversampling bandwidth which is acquired during every readout. The resulting movement signal, also called the Pilot Tone signal or cardiac component or cardiac component trace in this document, has quite a different shape than the ECG signal, and in particular does not feature a prominent R-wave. Extracting suitable time points for synchronization therefore presents new challenges and provides unique opportunities that require novel ways to extract the information and will enable novel applications.

The invention is defined by the claims, with embodiments of the invention defined by the dependent claims.

It is an object of the present invention to present a method for MR-acquisition, which makes use of the Pilot Tone signal and which allows novel ways of synchronizing the MR acquisition with the cardiac motion. It is further an object of the invention to provide new applications for Cardiac Pilot Tone synchronization.

The object is solved by a method according to claim 1. Particularly advantageous embodiments and features of the invention are given by the dependent claims. Features of different claim categories may be combined as appropriate to give further embodiments not described herein.

The Pilot Tone (PT) stands out as a simple and low-cost extension to an MR system/scanner that on the one hand has negligible hardware cost, since is using most of the existing hardware (MR receive and processing facilities, and potentially signal generation facilities), and, on the other hand, is constrained by the MR system's parameters, notably MR operating frequency, receiver bandwidth and maximal signal amplitude. The PT features more receiving channels than other methods (in a typical MR setup between 16 and 40 channels) distributed around the imaged volume of approx. diameter 50cm.

When comparing the different alternatives, the PT system turns out to be a very attractive option for cardiac motion state detection, in particular Pilot Tone contact-free cardiac synchronization, which was first described in Schroeder, L., Wetzl, J., Maier, A., Lauer, L., Bollenbeck, J., Fenchel, M., Speier, P. A "Novel Method for Contact-Free Cardiac Synchronization Using the Pilot Tone Navigator", Proceedings of the 24th Annual Meeting of the ISMRM, Singapur, 7.-13.5.2016, pp. 410, 2016.

Graesslin et al. describe in their paper "Advancements in Contact-Free Respiration Monitoring Using RF Pick-Up Coils", ISMRM 17. April 2010, page 3045, a method to detect respiratory motion, especially in the abdominal region which uses individual pick-up coils on each coil element to decouple the respiration monitoring from the actual imaging sequence. This is achieved by the integration short rectangular "monitoring pulses" into the pulse sequence.

*"*Feasibility Study: Free-Breathing 3-D Cine Imaging with Respiratory Gating Based on Pilot Tone Navigation", ISMRM 22. April 2016, page 2613, by Wetzl et al. discloses a comparison between pilot tone navigation for respiratory monitoring and respiratory signals derived from imaging data using sampling of the k-space center.

*"*Robust Self-Navigated Body MRI Using Dense Coil Arrays", Magnetic Resonance in Medicine, vol. 76 no.1, 29 July 2015 by Zhang et al. describe a motion estimation method using coil clustering for free-breathing body MRI. A modified self-navigating sequence was used to generate motion estimates.

*"*Self-Gated Golden Angle Spiral Cine MRI for Coronary Endothelial Function Assessment" ISMRM 7. April 2017, page 928, by Gabriele Bonanno et al. discloses a method which extracts cardiac self-gating data from the k-space center and correlates the data with simultaneously-recorded ECG.

Pilot Tone acquisition enables cardiac and respiratory synchronization based on PT signals, which are robust against setup variations and variations in patient physiology. The inventors have discovered that the multiple features of the cardiac component of the PT signal, which follows the cardiac contraction cycle, enable synchronization of the sequence to arbitrary cardiac phases, instead of synchronization to a single time point only (R-wave peak in the case of ECG).

Further embodiments of the invention are directed to how various clinically desirable applications can be improved or for the first time robustly realized using this new degree of freedom (the ability to synchronize the measurement or aspects of it to arbitrary cardiac phases).

The applications are distinguished between:
- Real time applications that detect the cardiac phase based on the PT in real-time and modify the execution of the sequence (e.g., trigger or gate), and
- Retrospective applications where a time interval of PT-CC is analysed during or after the measurement, and the results of the analysis are used to parametrize subsequent measurements, or for image reconstruction or post processing steps of the magnetic resonance signal from this or other time intervals. The analysis can, e.g., be carried out on a special calibration measurement and be applied to parametrize a subsequent clinical magnetic resonance scan, or the analysis can be carried out on one scan and the results be applied to guide the image reconstruction or post-processing of the same scan.

The method according to claim 1 is carried out - either in real-time or retrospectively - on a raw data signal acquired by a magnetic resonance receiver coil arrangement during a magnetic resonance scan. An MR-scan is an acquisition of magnetic resonance spectroscopy or imaging data from a human or animal, usually a patient, in particular from a moving part of the human or animal body (body part). The body part can be the heart or any other organ affected by motion, such as a blood vessel, thorax or lung, or more distal body parts, which are affected by the pulsatile arterial blood flow.

At least a portion of the body part is undergoing or is affected by a cyclical movement, namely cardiac movement. The method is usually carried out during the complete magnetic resonance scan, but may also be limited only to one or several stages or time intervals of the scan.

In a first step, a raw data signal acquired by a magnetic resonance receiver coil arrangement is received, typically from a clinical MR-scanner. The receiver coil arrangement can be a standard MR local coil having several channels, e.g. in the form of a coil array. Each channel acquires a separate signal component. Thus, the raw data signal comprises several, possibly complex, signal components. The receiver coil arrangement may have 4-128, preferably 8-64, receiver channels.

The raw data signal may be received and the inventive method carried out inline, i.e. on a control unit or computer associated with the MR scanner. Especially for retrospective applications, the method may also be carried out offline, i.e. on a remote server or computer available via a network connection.

In a next step, one needs to separate the magnetic resonance signal and the movement signal (i.e. the Pilot Tone signal) from the raw data signal. The movement signal is derived from and/or describes the mechanical activity of the moving body part, in contrast to ECG, which is derived from the electrical activity. The PT signal is modulated by the movement of the body part, since this movement influences the signal transmission between the source of the Pilot Tone signal and the receiver coil arrangement.

Once the Pilot Tone signal is separated from the raw data signal based on the frequency content, it is necessary to separate the movement signal relating to the cardiac movement (also called PT-CC for "Pilot Tone Cardiac Component") from the other Pilot Tone signal components. This can be done by principal component analysis (PCA) or independent component analysis (ICA). In preferred embodiments, a demixing matrix W separating the cardiac component from the other components is calculated from a short calibration scan. Once the demixing matrix has been calculated, it is applied to the incoming Pilot Tone signal to furnish the desired movement signal, namely the cardiac component.

In a next step, at least two physiological phases of the moving body part are assigned to the movement signal, wherein the automatic assignment does not introduce a delay between the movement signal and the medical scan signal. A physiological phase is preferably a phase in the cyclical movement, such as mid-diastole, end-diastole, etc. The term "physiological phase" may also indicate a particular time point or point of interest within the cyclical cardiac movement, such as the start and end of the mid-diastolic phase. The assignment is preferably done continuously, not just on the signal from one cardiac cycle. In this case, at least two physiological phases are assigned per cardiac cycle, e.g. end-systole and end-diastole.

The automatic assignment of the physiological phases is preferably done by applying an adaptive or stochastic or model-based filter to the movement signal, as will be described in more detail below.

This step allows the next step of automatic determination and/or setting of time points used for triggering an acquisition of the magnetic resonance signal (in real-time applications and/or for data-post processing the magnetic resonance signal (in retrospective applications). The automatic determination is preferably based on template and/or model-based feature detection within the movement signal, as will be described in more detail below. For real time applications, the last two steps are preferably carried out continuously with no delay during the whole or part of the acquisition of the raw data signal. For post-processing applications, the last two steps are also carried out for the whole or part of the movement signal, but not necessarily in real time.

Thus, the time points used for triggering or post-processing can be selected at any arbitrary physiological phase or point of interest in the movement signal. In particular, it is possible to select points of interest, which would not be possible with ECG triggering based on R-wave detection, e.g. because they are points shortly before the R-wave, or they are simply too remote from the R-wave to be reliably implemented in an arrhythmic heart, or they can be identified using additional cine imaging scans only.

Preferably, the time points for triggering are then transmitted to the MR scanner or its control unit, to be used during the MR acquisition. The time points used for post-processing may be used on an offline server.

The invention has the advantage of providing reliable ECG-free cardiac imaging. In comparison with known ECG-based imaging methods, the invention can be implemented at lower costs. Further, since no leads have to be attached to the patient, there is better patient comfort and the preparation time for the radiological examination is reduced. In addition, the method is more reliable than ECG, because there is no interference between the Pilot Tone signal and the MR signal, and thus provides increased triggering reliability.

The inventive method can reliably extract the desired time points also from patients with severe arrhythmia, since the physiological phases are automatically assigned to the movement signal (e.g. the cardiac component). The automatic assignment of the physiological phases (i.e. cardiac phases) to the movement signal is preferably performed by applying an adaptive or stochastic or model-based filter to the movement signal, in particular the cardiac component of the movement signal.

Contrary to ECG-based triggering, the inventive method allows a synchronization of the scan of medical data to arbitrary cardiac phases, also in arrhythmic hearts.

The physiological phases may comprise at least one of the following phases or points of interest in the cardiac movement: diastole, systole, mid-diastolic phase, mid-systolic phase and -systole, and -diastole, start and end of the mid-systolic phase, start and end of the mid-diastolic phase.

The filter preferably has to fulfil the following criteria: If the filtered movement signal is to be used in triggering, the filter may not introduce significant delay. Therefore, advanced filters like adaptive or stochastic or model-based filters are necessary.

It is further preferred that the filter not only suppresses noise of the cardiac component, but should also provide information about the relevant physiological phases, thus allowing automatic determination of trigger points. Since the movement signal is obtained by a completely different mechanism than an ECG signal, it does not have the distinctive R-wave, which can easily be used as trigger point. Rather, the movement signal has to be analysed to determine the physiological phases.

In a preferred embodiment, the adaptive or stochastic or model-based filter is first trained or adapted to the cardiac component, in particular to the cardiac component derived from a calibration portion. Alternatively, the filter adapts during the processing of the raw data signal acquired by the MR receiver coil arrangement, i.e. during the actual method.

The adaptive or stochastic or model-based filter often relies on an *a priori* model of the cardiac cycle in either the time and/or frequency domain. Model based filtering is robust against measurement noise and enables triggering on any, arbitrary points in the cardiac cycle. In the absence of severe arrhythmia, model based methods may also be able to predict cardiac activity beyond the current state. Therefore, model-based or stochastic filters are preferably applied to the movement signal.

Preferably, the filter is a Kalman Filter, or an Extended Kalman filter, or is a Switched/Switching Kalman Filter, wherein the Switching Kalman Filter switches between several models during various phases of the cyclical movement. Kalman filtering, also known as linear quadratic estimation (LOE), is an algorithm that uses a series of measurements observed over time, containing statistical noise and other inaccuracies, and produces estimates of unknown variables that tend to be more accurate than those based on a single measurement alone, by using Bayesian inference and estimating a joint probability distribution over the variables for each timeframe. Thus, the Kalman filter provides, on the basis of the past measurements, e.g. the calibration portion, for each filtered data point of the movement signal, a probably correct data point. The switched Kalman filter may also include information on the physiological phase of the data point, i.e. may already assign the physiological phase. The Kalman, Extended Kalman and Switched/Switching Kalman filter make us of prior information trained on actual data. Thus, these and other model-based filters make use of a model of the movement signal.

The underlying model for implementations using the (Extended) Kalman Filter/Smoother may be generated either in the frequency and/or time domain. Once such a model has been generated, e.g. by analysis of the cardiac component acquired during the calibration phase, segmentation can be achieved by various methods, such as Hidden Markov Models [8] or Switched Kalman Filters. These methods may also be used retrospectively to obtain segmentations of the cardiac component.

In some embodiment, the adaptive or stochastic or model-based filter uses a model which incorporates physiological information about the cyclic movement, in particular cardiac movement. Thus, the model may be based on a pre-configured model, which is however preferably adapted to the actual movement signal received during the scan of medical data, such as a Hidden Markov Model.

"Automatically assigning" means that the assignment is performed without user input and is preferably done by the filter operation as described above. Thus, the filter preferably identifies sections or points of interest of the movement signal and allocates the physiological phases of the cyclical movement to the identified sections or points of interest.

In real-time applications, the step of assigning the physiological phases is preferably performed such that no delay is introduced between the movement signal and the magnetic resonance signal acquired at the same time as the movement signal. The term "no delay" means that the delay is preferably kept to a minimum, preferably between 0-10ms and more preferred less than 1ms, so that the time points used for triggering are effectively generated in real time. Hence, they can be used for triggering the MR scan in which the raw data signal including the MR data is acquired.

When no real-time functionality is needed, forward-backward filtering using either FIR or IIR digital filters in the time-domain or frequency-domain filtering on the cardiac component may be used to generate a filtered movement signal, on which feature detection algorithms (such as the above-described adaptive or stochastic or model-based filters) can be applied to assign the physiological phases. "Forward-backward filtering" is a filter method which ensures that the filtered movement signal is not shifted in time by the filter, so there is no delay between the images acquired during the scan of medical image data and the movement signal derived from the Pilot Tone signal (even if they are not processed in real time).

In a next step, the time points used for triggering the acquisition of the magnetic resonance signal and/or for data post-processing of the magnetic resonance signal are automatically determined and/or set. The time points are extracted from the, preferably filtered, movement signal.

This is preferably done by template- or model-based feature detection, which may already be part of the filtering step with a stochastic or adaptive or model-based filter such as the Kalman filter, as described above. Alternatively, the movement signal (i.e. the cardiac component) may first be filtered for denoising and then analysed.

For example, the first and/or second derivative of the (filtered) movement signal is calculated and automatically analysed to extract time points used for triggering or post-processing.

Possible useful trigger points are: max(abs(1st derivative)) = max velocity or max(abs(2nd derivative)) = max acceleration or the minimum/maximum of the cardiac component trace. These points are easily obtained from the smoothed cardiac component and correspond to interesting features in the cardiac cycle like the early systolic and diastolic phases. Trigger points approximating the ECGs R-peak may be obtained by threshold based triggering using the mid-diastolic amplitude as an indicator.

In useful embodiments a user will first define physiological phases or points of interest, at which the time points are to be set in the movement signal. Alternatively, the user only selects the type of MR-examination desired and the control unit of the MR-scanner automatically determines at which physiological phase or point of interest triggers are required. Then, acquisition of the magnetic resonance signal and movement signal starts and the selected phases or points of interest are automatically extracted from the movement signal by the steps described above.

When time points are defined by a user, it may be practical to first display the cardiac component to the user, for example by showing the movement signal, averaged over several cardiac cycles, for the length of one or two cycles. The user can then set the desired time points by means of a user interface including e.g. a mouse, touch-screen or the like. Once the points are thus defined, they will be extracted automatically from the incoming movement signal.

According to preferred embodiments, the movement signal reflects the heart beat and the time points are determined independently from the R-wave and/or other electrical activity of the heart. This is possible if the movement signal is the cardiac component of the Pilot Tone signal, since the Pilot Tone is not affected by electrical activity of the heart, but reflects the actual movement occurring in the volume near the Pilot Tone emitter and the receiver coil elements. During Brain imaging, the Pilot Tone emitter could be placed on the chest and a chest coil arrangement is using only for Pilot Tone acquisition, while the head coil channels are used for imaging.

In the following, suitable embodiments of cardiac real-time applications shall be described in more detail.

The methods are based on the minimal (or no) delay in the processing of the movement signal, and template feature detection. Besides arbitrary user-defined points, one may use:
Minima and maxima of the cardiac component, max(abs(1st derivative)) = max velocity, max(abs(2nd derivative)) = max acceleration

Any assignment of physiological phases (event flagging) based on the detected feature will take into account the processing delay.

According to a useful embodiment, at least one time point for triggering is automatically set in the R-R interval preceding the cardiac cycle during which the corresponding magnetic resonance signal is acquired. This would not be possible with ECG triggering, which naturally does not allow a trigger shortly before the R-wave. This is particularly useful for the acquisition of magnetic resonance signals from the systolic phase which require a long preparation period (e.g., inversion pulse and subsequent wait time), and therefore at least one time point for triggering a preparation pulse is automatically set during the diastolic phase preceding the systolic phase. When the moving body part is the heart, it may be advantageous to acquire magnetic resonance data in the systolic state, because the myocardium is thicker in systole, which simplifies the analysis (e.g. reduced contamination of blood pool). Further, for patients with fast heart rates and paediatric patients, the silent period of the heart is often longer in systole than in diastole. In this embodiment, a "long" preparation period means long by MR-sequence standards, such as 20-400 ms.

Examples for this embodiment (systolic acquisition) possibly with preparation pulses in the preceding diastolic phase) are:
Example 1: Stable myocardial Late Gadolinium Enhancement (LGE) magnetic resonance imaging. The concept of LGE is based on the delayed wash-in and wash-out of Gd-containing contrast agent in myocardial tissue affected by infarction. The increased amount of Gd in the extracellular space in the infarcted tissue can be demonstrated by T1-weighted imaging in a time period of 10-30 minutes after contrast administration. The techniques used for LGE-imaging in end-systole require usually an inversion recovery (IR) pulse, which must be played out in the previous R-cycle, since the inversion time is fixed by the MR imaging protocol. Thus, if LGE-imaging during systole is desired, the IR-pulse must be triggered in the preceding cardiac cycle.
Example 2: T1 mapping in systole. For the evaluation of the heart, in particular to evaluate infarction, it is crucial to have as many pixels in myocardium as possible (transmural), but without including blood pool or air, which would lead to big errors. A larger diameter of the myocardium, as can be seen in the state of maximum ventricular contraction, is therefore an advantage. However, T1-mapping again requires a long preparation period, namely an inversion recovery or saturation pulse followed by a predetermined inversion time. Thus, if the data readout is to take place during systole, it is advantageous to be able to play out the inversion pulse out in the previous RR-cycle.
Example 3: STIR-imaging. In STIR-imaging (Short TI Inversion Recovery), the fat signal is inverted and the signal is read out when fat crosses zero. To perform STIR at systole, also the required inversion pulse might need to be played out before the ECG-trigger time point at the R-wave, thus in the end-diastolic phase.

According to a further embodiment, the time points used for triggering are used to optimise a MOLLI-type measurement. "MOLLI" stands for "Modified Look-Locker Imaging". The basic strategy is to use only 2-3 inversion pulses followed by several single-shot b-SSFP (balanced steady-state-free precession) read-outs at various fixed inversion times. Short rest periods are interspersed to allow recovery of longitudinal magnetisation between cycles. In conjunction with parallel imaging and conjugate symmetry methods, MOLLI allows accurate T1-values of myocardium to be obtained in only one breath-hold per slice.

MOLLI and other cardiac T1 quantification types (sh-MOLLI, SASHA, etc.) require a series of images to be acquired at the same cardiac phase, but with varying inversion time. The signal evolution would be best characterised if the TI values are well distributed without bunching, e.g. spaced evenly, or with smoothly varying distances. However, the presently used ECG triggering on the R-wave limits the variations possible. Inventive triggering on an arbitrary phase allows to place the inversion pulse without restrictions and thus allows realisation of an optimal distribution of TI points. Thus, MOLLI-type measurements with evenly distributed T1 points are possible.

According to further useful embodiments, a time point used preferably for triggering a preparation pulse is moved along the cardiac cycle for different repetitions of the magnetic resonance sequence, or for the acquisition of different sub-sections of k-space. This will allow to optimise the contrast in cardiac MR-imaging, e.g. since it allows to acquire the central sub-section of k-space during periods of optimal contrast, and outer portions during periods of less ideal contrast as described in DE 10 2005 051 323 A1. Further, a contrast may be stabilised for the central portion of k-space while full coverage of cardiac cycle is generated. The advantage of using the Pilot Tone over the ECG is here again, that time points are relative to the heart motion, not relative to the R-wave, thus more stable in case of changing heart rate or arrhythmia

As an example, this embodiment may be applied to contrast-prepared CINE-images. CINE images are short movies that are able to show heart motion throughout the cardiac cycle. In the prior art, CINE images were obtained with ECG triggered segmented imaging. Segmented acquisition is the process of dividing the cardiac cycle into multiple segments (frames) to produce a series of images that can be displayed as a movie (CINE). Each image in the CINE is typically composed of information gathered over several heart beats allowing for a movie to be acquired in a breath-hold of 10-20s depending on the sequence. As in any movie, the final CINE is a sequence of individual frames.

The MR sequence may for example be an inversion or saturation prepared CINEAST, tagging or DENSE imaging. In such sequences with a preparation pulse, contrast varies across the cardiac cycle as the magnetization preparation fades into the readout steady state. Optimal contrast may occur directly after preparation or a certain time after preparation. The resulting contrast can be stabilized along the cardiac cycle by moving the preparation along the cardiac cycle for different repetitions of the sequence or during acquisition of different sub-sections of k-Space and combining the resulting data intelligently. The most simple approach is to acquire after preparation only one or a few phases of the cardiac cycle. Other approaches acquire central k-Space during periods of optimal contrast and outer portions during periods of less ideal contrast. The inventive method, i.e. Pilot Tone triggering, allows to move the start of the sequence or the preparation pulse not only to different phases of the cardiac cycle but also to the preceding RR interval and thus allows to fill gaps in the existing applications, like the early systolic phase in tagging or IR prepared cine. By removing this limitation, longer and thus more effective or elaborate preparations can be used without loss of coverage of the cardiac cycle.

According to another useful embodiment, the sequence could use multiple trigger time points simultaneously: one to prepare the contrast, and one to start and stop the acquisition, or two separate acquisitions targeting different cardiac phases. Thus, several time points per cardiac cycle could be extracted from the movement signal and used to control different events in a sequence.

According to another useful embodiment, a time point used for triggering is set on the onset of the mid-diastolic phase for acquiring an image data set of the end diastolic state. The invention thus allows robust acquisition of end diastolic images in the presence of heart rate variations. While the time (after R-wave) of the end-systolic phase is quite independent of heart rate, the time of mid-diastolic phase scales with the heart rate in a patient-specific fashion. Therefore, segmented high resolution diastolic images can become blurred when the heart rate varies during acquisition. By triggering directly on the onset of the mid-diastolic phase the positioning of the acquisition window and thus the image quality can be stabilized for most applications.

According to another useful embodiment, the movement signal is analysed for a characterization of arrhythmic heart beats, in particular in order to reject the magnetic resonance signal acquired during an arrhythmic heartbeat. Based on shape similarity measures, heartbeats can be categorized and processed separately; in the simplest implementation, data belonging to some categories could be rejected. This embodiment can be performed in real-time, but can be a retrospective application as well.

The next embodiments are preferably performed as retrospective applications, but could be real-time applications as well. For retrospective applications, preferably the movement signal (the cardiac component of the Pilot Tone signal) is stored together with the magnetic resonance signal and exported together with the DICOM data to support post processing. For delay-free offline processing, preferably a delay-free filtering method, such as forward/backward-filtering, is used. On the filtered movement signal, a template-based feature detection may be performed to assign the physiological phases of the moving body part to the movement signal, and for determining the time points used for data post-processing.

For training the filter or for deriving a model for the template-based feature detection, one may for example use data of the current or a previous scan, in which raw data was acquired. This could be a special Pilot Tone calibration scan or a previous scan of the MR-exam, e.g. a localiser scan.

According to a preferred embodiment, the time points for data post-processing or for triggering are set at distinct motion states, in particular at end-systolic and/or end-diastolic time points. These time points would indicate maximum and minimum contraction of the heart and would allow very interesting image processing, e.g. when a scaling of a time axis is required (see below). The time points can be used as input for inline or offline post-processing of the acquired magnetic resonance signal.

According to another useful embodiment, the time points are set at time points of average strain in order to place strain-sensitive measurements there, in particular diffusion measurements. These points can be found under the assumption that the relationship between strain and signal modulation of the cardiac component of the PT (i.e. the movement signal) is linear: Then the time points of average strain correspond to the time points where the PT-CC assumes its time averaged value (averaged over a cardiac cycle).

According to a further preferred embodiment, the time points are set at optimal time points for motion sensitive dark blood preparation, in particular at time points of maximum slope in the movement signal (i.e. at maximum velocity) or of maximum second order derivative of the movement signal (i.e. at maximum acceleration). This is useful for the Dark Blood technique using flow based blood suppression, e.g. described in Nguyen TD, de Rochefort L, Spincemaille P, et al. Effective Motion-Sensitizing Magnetization Preparation for Black Blood Magnetic Resonance Imaging of the Heart. Journal of magnetic resonance imaging: JMRI. 2008;28(5) :1092-1100. doi:10.1002/jmri.21568. MR black blood techniques are therefore suitable to segment myocardium from the blood pool. When using the inventive method, the preparation pulses can be ideally placed within the cardiac cycle, in particular motion sensitized preparation blocks can be placed on time points of maximum slope in the cardiac component, corresponding to maximum contraction velocity of the myocardium, for M1 sensitised modules. Alternatively, the preparation can be triggered by time points corresponding to maxima of the second derivative of the cardiac component for acceleration sensitive modules.

According to another useful embodiment, the time points are used for positioning acquisition windows to specific time periods, in particular to silent periods in a cardiac interval. For static MR measurements, the organ should not move significantly during the acquisition to avoid artefacts or blurring. For cardiac imaging, this means that acquisitions are limited to windows of negligible cardiac motion, such as end-systolic phase, mid- and end-diastolic phase.

According to another useful embodiment, the time points for data post-processing are used for matching the time resolution of retro-gated CINE images. With the inventive method, the frames can be retrospectively distributed, or the time resolution changed, in order to match the time resolution to each cycle and to the physiology to avoid under-estimation of cardiac activity. The principle is as follows:
To reduce scan time, cardiac phase time resolution is on the order of 35-50ms. If the end-systolic phase falls in the middle of a reconstructed frame, the maximum contraction is most optimally characterized. If it is distributed across two frames, the contraction is underestimated. The positions of reconstructed frames for retro-gated CINEs can be freely selected during reconstruction. If one places the frames according to the position of the end-systolic phase as determined by the inventive method from the PT-CC data (the cardiac component of the Pilot Tone signal), then underestimation of the cardiac contraction is minimized. This embodiment can be performed in real-time as well.

According to a further embodiment, time points for triggering or data post-processing of a magnetic resonance signal acquired across multiple heart beats are set according to features of the movement signal or models thereof. This is a feature only possible with invention, which allows the extraction of such features from the PT-CC signal. For example, when the time points are set along a time axis, a non-linear scaling of the time axis may be performed when the heart rate changes during the acquisition. Combining images or segmented k-Space data measured across multiple heart beats require scaling the time axis if the heart rate changes during the acquisition. The scaling is generally non-uniform (rule of thumb: duration of systole stays nearly constant, diastole stretches) and patient specific. Image quality can be optimized, if the interpolation rule is derived from previous scans or the same scan and is applied during reconstruction or assembly of the data. According to this embodiment of the invention, the relevant features of the cardiac movement can be extracted from the movement signal, and the time points can be scaled in an optimized manner in each cardiac cycle.

Preferred embodiments of the invention shall now be described with reference to the appended drawings, in which:
- Fig. 1: shows a schematic flow diagram of an embodiment of the inventive method.
- Fig. 2: shows an example of a cardiac component over one cardiac cycle, and its 1st and 2nd derivative.
- Fig. 3: shows a schematic Bandpass-filtered cardiac component trace and corresponding ECG trace, wherein the Triggers (vertical dashed lines) were extracted from the ECG.
- Fig. 4: shows an example of a cardiac component over one cardiac cycle, and relevant trigger points.
- Fig. 5: shows an MR-scanner in a schematic view.

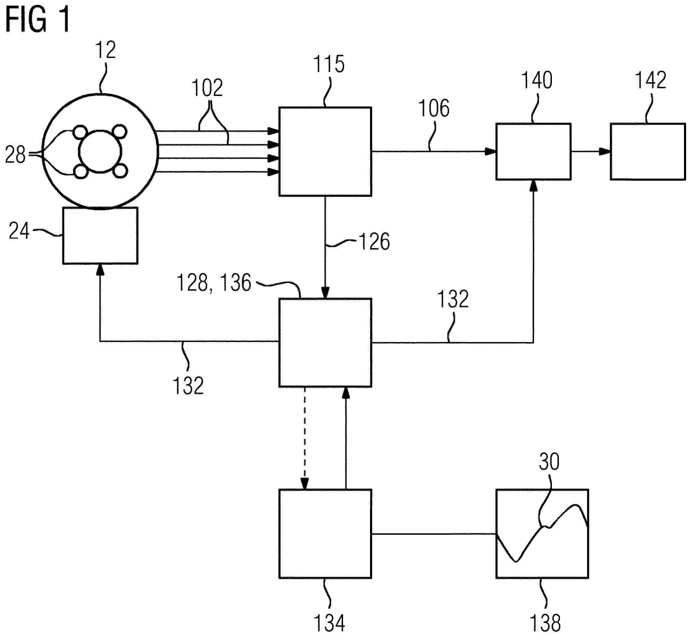

In the following and with reference to Fig. 1, we shall give an overview of an embodiment of the inventive method. In the example, we assume that a Pilot Tone signal is acquired during an MR scan. The processing of the acquired raw data signal may include the following steps:
1) Calibration step: These steps can be the same as described in the DE 10 2015 224 162 A1. The purpose of the calibration step is to determine the frequency of the Pilot Tone signal and to separate the magnetic resonance imaging signal from the additional Pilot Tone signal.
2) Pre-processing step: Optionally Down-sampling the Pilot Tone signal (consisting of several signal components from the several receiving coil channels) and optionally low-pass filtering or bandpass filtering to suppress unwanted signals, such as the respiratory signal, and normalizing the phases of all channels to a reference phase.
3) Processing step: Calculating a demixing matrix W separating the cardiac component by applying an independent component analysis (ICA), in particular from a short calibration scan, and applying the demixing matrix on incoming data.
4 a) Filtering/triggering step: For real-time applications, denoising of the cardiac component and feature detection to enable triggering on an arbitrarily positioned predefined points in the cardiac cycle.
4 b) Filtering/post-processing step: For retrospective applications, retrospective processing of the cardiac component and the feature extraction.
5) Visualization step: Optionally, real-time visualization of the filtered movement signal, i.e. the processed cardiac component.

Fig. 1 centres in particular on steps 4 a) and 4 b): The MR scanner 12 including a receiver coil arrangement 28 with (in this schematic example) four coils/channels is shown on the top left. When the acquisition starts, the receiver coil arrangement acquires a raw data signal 102 having 4 signal components, from which the magnetic resonance signal 106 and the movement signal 126, namely the cardiac component of the Pilot Tone signal, are separated in step 115. Step 115 also includes the calibration, pre-processing and processing steps 1 to 3 listed above.

The movement signal 126 is then subjected to a filtering step 128 as described above, which includes the automatic assigning of the physiological phases to cardiac component 126. In preferred embodiments, the filter may first be trained on a calibration portion of the movement signal. Since the filter usually takes some time to converge, using calibration data a priori speeds up conversion for the actual scan. However, in other applications, the filter 128 adapts over time to the incoming movement signal 126 and does not require a calibration.

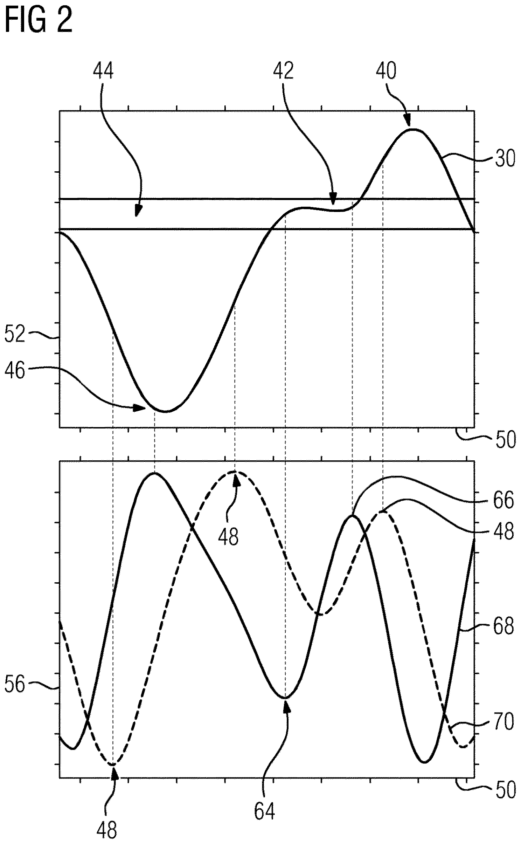

Some physiological phases which may be assigned to the cardiac component are shown in Fig. 2 described below.

Returning to Fig. 1, at the same time or after the filtering step 128, time points 132 for triggering or post-processing may be automatically set in the filtered movement signal, or may be set automatically by the filter. As described above, an adaptive or stochastic or model-based filter may be able to adapt a model of the movement signal so that each incoming data point is automatically fitted to the model and thus its physiological phase, in particular its position with the cardiac cycle, is known. The steps 128/136 can be performed continuously and in real time on the incoming movement signal 126.

Optionally, the physiological phases or points of interest where the time points are to be set are selected in a step 134. This step may be inherent in the selection of the MR protocol used for the acquisition of the raw data signal 102, or it may require user interaction. In this case, the movement signal 30 may be displayed on a screen 138 and the user selects arbitrary time points within the cardiac cycle. Alternatively, the user describes the desired time points, such as "Maximum of first derivative". This information is passed on and used in step 136 in the determination of the time points 132.

Thus, time points 132 to be used for triggering or post-processing are continuously generated. In real time applications, these time points for triggering are fed to the control unit 24 of the MR scanner 12 and used in the acquisition of the raw data signal, in particular of the magnetic resonance signal. Alternatively or additionally, in retrospective applications, time points 132 are also extracted and are used in a post-processing step 140 of the magnetic resonance signal 106. From such post-processing, a magnetic resonance image 142 may result.

The movement signal may be filtered in step 128 as described above, e.g. by a switched Kalman filter based on a model generated by analysis of the cardiac component acquired during a calibration phase. The filtered movement signal, i.e. the cardiac component 30, is shown in the top graph of Fig. 2, in a plot of amplitude 52 in arbitrary units versus time 50. In the bottom part of the graph, the first derivative 70 (in dashed line) and second derivative 68 of the filtered movement signal/cardiac component are also shown in arbitrary units 56 plotted against time 50. From the filtered cardiac component trace, the following points of interest can be derived: The minimum of the cardiac component trace 46 indicates systole, i.e. the maximum contraction and resting phase. The maximum of the cardiac component phase 40 indicates end-diastole, i.e. the physiological phase of maximum expansion of the heart during the resting phase. The plateau 42 can be associated with the mid-diastolic phase, in which the ventricle is relaxed, i.e. a resting phase. The area 44 indicates the signal level for R wave occurrence, and may be used in a threshold trigger. The minima and maxima of the first derivative 70 of the cardiac component indicate the times of maximum velocity. The minimum 64 and the maximum 66 of the second derivative 58 indicate the start and end of the mid-diastolic phase.

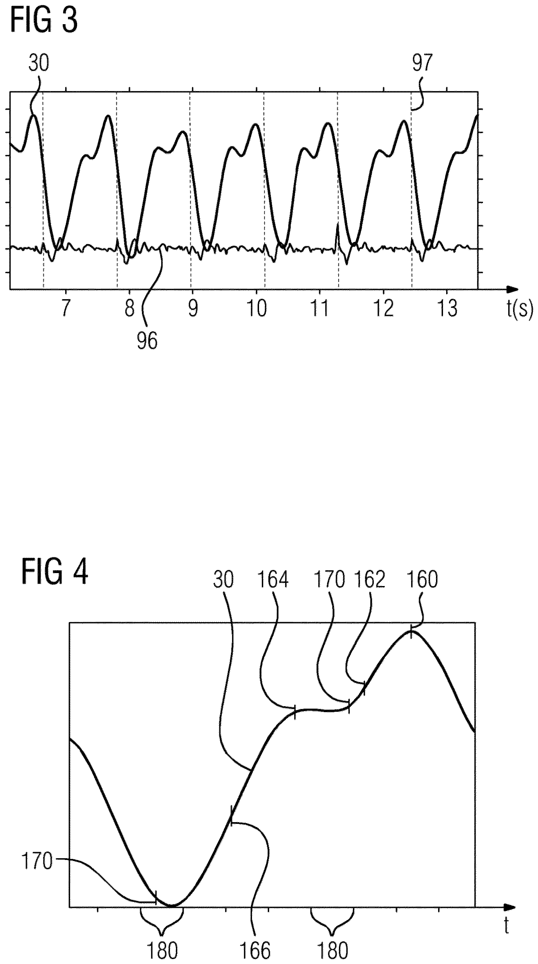

Fig. 3 is an illustration of a possible visualisation step. In this figure, the cardiac component trace 30 is plotted over six cardiac cycles against time, wherein the cardiac component trace 30 is shown over a time span of about 7 seconds. The cardiac component trace 30 has been band-pass filtered before. A corresponding ECG trace 96 is also plotted, where the respective R waves are shown as dashed lines 97.

Fig. 4 shows an example of a filtered cardiac component 30 over one R-R interval, and various time points which may be determined/set in accordance with embodiments of the invention. For example, 160 indicates a trigger point at end-diastole, which may be used for a preparation pulse for acquiring an image such as LGE in the systolic phase of the next R-R cycle (not shown). Time points 162, 164 and 166 illustrate how trigger points, e.g. for triggering a preparation pulse, are moved along the cardiac cycle for different repetitions of an MR sequence. Thereby, the contrast can be optimised, as described above.

Time points 170 illustrate time points of maximum second order derivative of the movement signal, i.e. time points of maximum acceleration. These time points may be useful in dark blood imaging.

Further, the cardiac component 30 may be divided into frames to be used in CINE imaging, by means of a number of time points 180 distributed over the cardiac cycle. In retro-gated CINEs, it is possible to match the time resolution to the individual cardiac cycle. Thus, by selecting the position of the time points 180 according to their physiological phase, and not according to a pre-determined time resolution, image quality can be improved. In particular, one trigger point 180 should be set so that the end-systolic phase falls into one frame. Generally, the sequence of time points 180 may be distributed not in constant time intervals, but each position in each cycle may be adapted to the physiological phases in that particular cardiac cycle.

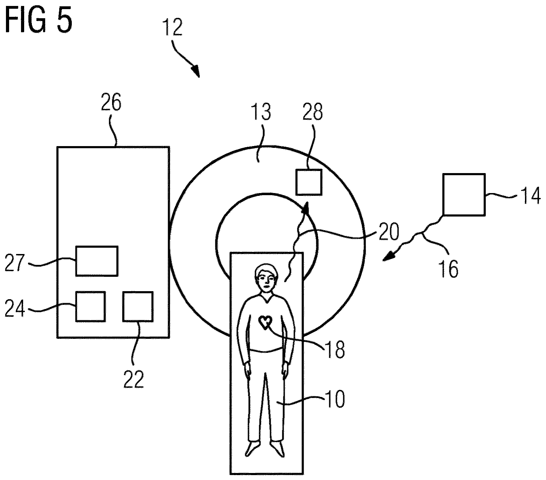

Fig. 5 finally shows a schematic MR scanner 12. The MR-scanner 12 includes a main magnet 13 and a control unit 24, by which the data acquisition of the MR scanner 12 can be controlled. The control unit 24 can be part of a computer device 26. The computer device can also include a digital storage medium 22 and a User interface 27 including e.g. a display, a keyboard, mouse, touch screen or such like. A patient 10 may be examined, in particular in order to perform MR imaging of the heart 18.

In order to provide the movement signal, a pilot tone signal 16 is emitted by a pilot tone emitter 14, which may be a separate RF source. Preferably, the pilot tone emitter 14 is positioned close to the heart, e.g. strapped to the local coil 28 or included in the coil. In the figure, the pilot tone emitter 14 is shown within the bore of the main magnet 13. The pilot tone signal is modulated by the movement of the heart 18 and the lung (not shown).

The (modulated) pilot tone signal is received by the receiver coil arrangement 28, which is preferably a local coil 28, such as a head coil or chest array coil, but may also be the body coil.

## Claims

1. Method for generating a medical data set (142), which is an image data set, of a moving part (18) of the human or animal body, undergoing a cyclical movement such as cardiac movement, comprising the following steps:
a) receiving a raw data signal (102) acquired by a magnetic resonance receiver coil arrangement (28),
**characterised by** the following steps:
b) separating a magnetic resonance signal (106) and a movement signal (126) from the raw data signal, wherein the movement signal is derived from and/or describes the mechanical activity of the moving body part (18) within a movement cycle, wherein the movement signal (126) is the cardiac component (30) of a Pilot Tone signal,
c) automatically assigning at least two physiological phases (40, 42, 46, 48) of the moving body part to the movement signal (30), wherein the automatic assignment does not introduce a delay between the movement signal and the magnetic resonance signal,
d) automatic determination and/or setting of time points (160, 170, 180) used for triggering an acquisition of the magnetic resonance signal and/or for data post-processing of the magnetic resonance signal, wherein the time points are extracted from the movement signal.

2. The method according to claim 1, wherein the automatic determination is based on template and/or model based feature detection (136) within the movement signal.

3. The method according to one of the preceding claims,
wherein the first (70) and/or second (68) derivative of the movement signal (30) is provided and used in the automatic determination and/or setting of time points.

4. The method according to one of the preceding claims,
wherein prior to the automatic determination of the time points, a user defines the physiological phase or point of interest at which the time points (160, 170, 180) are to be set in the movement signal (30).

5. The method according to one of the preceding claims,
wherein the time points (160, 170, 180) can be selected at any point of interest in the movement signal (30).

6. The method according to one of the preceding claims,
wherein at least one time point (160) for triggering is automatically set in the R-R interval preceding the cardiac cycle during which the corresponding magnetic resonance signal is acquired.

7. A method according to claim 6, wherein the acquisition of the magnetic resonance signal requires a long preparation period and at least one time point (160) for triggering a preparation pulse is automatically set during the diastolic phase preceding the systolic state.

8. A method according to one of the preceding claims,
wherein time points (162, 164, 166) used in particular for triggering a preparation pulse are moved along the cardiac cycle for different repetitions of the magnetic resonance sequence, or for the acquisition of different sub-sections of k-Space.

9. A method according to one of the preceding claims,
wherein the time points (40, 46) for data post-processing are set at extreme motion states, in particular at end-systolic and/or end-diastolic time point.

10. A method according to one of the preceding claims,
wherein the time points are set at time points of average strain in order to place strain sensitive measurements there, in particular diffusion measurements.

11. A method according to one of the preceding claims,
wherein the time points (170) are set at optimal time points for motion sensitive dark blood preparation, in particular at time points of maximum slope in the movement signal or of maximum second order derivative of the movement signal.

12. A method according to one of the preceding claims,
wherein the time points (180) for data post-processing are used for matching the time resolution of retro-gated cinematic or cine images, such that underestimation of cardiac activity is avoided.

13. A method according to one of the preceding claims,
wherein the time points (180) for triggering or data post-processing of magnetic resonance signal acquired across multiple heart beats are set according to features of the movement signal or models thereof.

14. A computer program comprising program code which induces a computer (26) to perform a method according to any one of the preceding claims, when the program code is executed on the computer.

15. A control unit (24) adapted for performing the method according to one of claims 1 to 13.

## Patentansprüche

1. Verfahren zum Generieren eines medizinischen Datensatzes (142), bei dem es sich um einen Bilddatensatz handelt, eines bewegten Teils (18) des menschlichen oder tierischen Körpers, der eine zyklische Bewegung wie etwa eine Herzbewegung durchläuft, umfassend die folgenden Schritte:
a) Empfangen eines Rohdatensignals (102), das durch eine Magnetresonanz-Empfangsspulenanordnung (28) erfasst wird,
**gekennzeichnet durch** die folgenden Schritte:
b) Trennen eines Magnetresonanzsignals (106) und eines Bewegungssignals (126) von dem Rohdatensignal, wobei das Bewegungssignal von der mechanischen Aktivität des bewegten Körperteils (18) innerhalb eines Bewegungszyklus abgeleitet wird und/oder diese beschreibt, wobei das Bewegungssignal (126) die Herzkomponente (30) eines Pilottonsignals ist,
c) automatisches Zuweisen von wenigstens zwei physiologischen Phasen (40, 42, 46, 48) des bewegten Körperteils zu dem Bewegungssignal (30), wobei die automatische Zuweisung keine Verzögerung zwischen dem Bewegungssignal und dem Magnetresonanzsignal einführt,
d) automatische Bestimmung und/oder Einstellung von Zeitpunkten (160, 170, 180), die zum Auslösen einer Erfassung des Magnetresonanzsignals und/oder zur Datennachverarbeitung des Magnetresonanzsignals verwendet werden, wobei die Zeitpunkte aus dem Bewegungssignal extrahiert werden.

2. Verfahren gemäß Anspruch 1, wobei die automatische Bestimmung auf einer vorlagen- und/oder modellbasierten Merkmalsdetektion (136) in dem Bewegungssignal basiert.

3. Verfahren gemäß einem der vorstehenden Ansprüche, wobei die erste (70) und/oder die zweite (68) Ableitung des Bewegungssignals (30) bereitgestellt wird und bei der automatischen Bestimmung und/oder Einstellung von Zeitpunkten verwendet wird.

4. Verfahren gemäß einem der vorstehenden Ansprüche, wobei vor der automatischen Bestimmung der Zeitpunkte ein Benutzer die physiologische Phase oder den Punkt von Interesse definiert, an dem die Zeitpunkte (160, 170, 180) in dem Bewegungssignal (30) einzustellen sind.

5. Verfahren gemäß einem der vorstehenden Ansprüche, wobei die Zeitpunkte (160, 170, 180) an einem beliebigen Punkt von Interesse in dem Bewegungssignal (30) ausgewählt werden können.

6. Verfahren gemäß einem der vorstehenden Ansprüche, wobei wenigstens ein Zeitpunkt (160) zum Auslösen automatisch in dem R-R-Intervall vor dem Herzzyklus einstellt wird, in dem das entsprechende Magnetresonanzsignal erfasst wird.

7. Verfahren gemäß Anspruch 6, wobei die Erfassung des Magnetresonanzsignals eine lange Vorbereitungsperiode erfordert und wenigstens ein Zeitpunkt (160) zum Auslösen eines Vorbereitungsimpulses automatisch während der diastolischen Phase vor dem systolischen Zustand eingestellt wird.

8. Verfahren gemäß einem der vorstehenden Ansprüche, wobei Zeitpunkte (162, 164, 166), die insbesondere zum Auslösen eines Vorbereitungsimpulses verwendet werden, entlang des Herzzyklus für unterschiedliche Wiederholungen der Magnetresonanzsequenz oder für die Erfassung unterschiedlicher Unterabschnitte des k-Raums verschoben werden.

9. Verfahren gemäß einem der vorstehenden Ansprüche, wobei die Zeitpunkte (40, 46) zur Datennachverarbeitung bei extremen Bewegungszuständen eingestellt werden, insbesondere an endsystolischen und/oder enddiastolischen Zeitpunkten.

10. Verfahren gemäß einem der vorstehenden Ansprüche, wobei die Zeitpunkte zu Zeitpunkten einer durchschnittlichen Belastung eingestellt werden, um belastungsempfindliche Messungen dort zu platzieren, insbesondere Diffusionsmessungen.

11. Verfahren gemäß einem der vorstehenden Ansprüche, wobei die Zeitpunkte (170) zu optimalen Zeitpunkten für eine bewegungsempfindliche Dunkelblutvorbereitung eingestellt werden, insbesondere zu Zeitpunkten einer maximalen Steilheit des Bewegungssignals oder einer maximalen Ableitung zweiter Ordnung des Bewegungssignals.

12. Verfahren gemäß einem der vorstehenden Ansprüche, wobei die Zeitpunkte (180) zur Datennachverarbeitung zum Abstimmen der Zeitauflösung von kinematischen oder Cine-Bildern mit "Retro-Gating" verwendet werden, sodass eine Unterschätzung von Herzaktivitäten vermieden wird.

13. Verfahren gemäß einem der vorstehenden Ansprüche, wobei die Zeitpunkte (180) zum Auslösen oder zur Datennachverarbeitung von Magnetresonanzsignalen, die über mehrere Herzschläge erfasst werden, gemäß Merkmalen des Bewegungssignals oder Modellen davon eingestellt werden.

14. Computerprogramm, umfassend Programmcode, der einen Computer (26) dazu veranlasst, ein Verfahren gemäß einem der vorstehenden Ansprüche durchzuführen, wenn der Programmcode auf dem Computer ausgeführt wird.

15. Steuereinheit (24), die dazu ausgelegt ist, das Verfahren gemäß einem der Ansprüche 1 bis 13 durchzuführen.

## Revendications

1. Procédé de création d'un ensemble (142) de données médicales, qui est un ensemble de données d'image d'une partie (18) mobile du corps humain ou animal subissant un mouvement cyclique, tel qu'un mouvement cardiaque, comprenant les stades suivants :
a) recevoir un signal (102) brut de données acquis par un agencement (28) de bobine réceptrice à résonance magnétique,
**caractérisé par** les stades suivants :
b) séparation d'un signal (106) de résonance magnétique et d'un signal (126) de mouvement du signal brut de données, dans lequel le signal de mouvement est dérivé de et/ou décrit l'activité mécanique de la partie (18) mobile du corps dans un cycle de mouvement, dans lequel le signal (126) de mouvement est la composante (30) cardiaque d'un signal Pilot Tone,
c) assignation automatiquement d'au moins deux phases (40, 42, 46, 48) physiologiques de la partie mobile du corps au signal (30) de mouvement, dans lequel l'assignation automatique n'introduit pas un retard entre le signal de mouvement et le signal de résonance magnétique,
d) détermination et/ou fixation automatique des instants (160, 170, 180) utilisés pour déclencher une acquisition du signal de résonance magnétique et/ou pour un post-traitement de données du signal de résonance magnétique, les instants étant extraits du signal de mouvement.

2. Procédé suivant la revendication 1, dans lequel la détermination automatique repose sur un gabarit et/ou un modèle reposant sur une détection (136) de particularité dans le signal de mouvement.

3. Procédé suivant l'une des revendications précédentes, dans lequel on se procure la dérivée première (70) et/ou seconde (68) du signal (30) de mouvement et on l'utilise dans la détermination et/ou la fixation automatique des instants.

4. Procédé suivant l'une des revendications précédentes, dans lequel, avant la détermination automatique des instants, un utilisateur définit la phase physiologique ou le point auquel on s'intéresse où les instants (160, 170, 180) doivent être fixés dans le signal (30) de mouvement.

5. Procédé suivant l'une des revendications précédentes, dans lequel les instants (160, 170, 180) peuvent être sélectionnés en tout point auquel on s'intéresse dans le signal (30) de mouvement.

6. Procédé suivant l'une des revendications précédentes, dans lequel on fixe automatiquement au moins un instant (160) de déclenchement dans l'intervalle R-R précédant le cycle cardiaque pendant lequel le signal de résonance magnétique correspondant est acquis.

7. Procédé suivant la revendication 6, dans lequel l'acquisition du signal de résonance magnétique exige une longue période de préparation et au moins un instant (160) de déclenchement d'une impulsion de préparation est fixé automatiquement pendant la phase diastolique précédant l'état systolique.

8. Procédé suivant l'une des revendications précédentes, dans lequel des instants (162, 164, 166) utilisés, en particulier pour déclencher une impulsion de préparation, sont déplacés le long du cycle cardiaque pour des répétitions différentes de la séquence de résonance magnétique, ou pour l'acquisition de sous-parties différentes de l'espace k.

9. Procédé suivant l'une des revendications précédentes, dans lequel les instants (40, 46) pour un post-traitement de données sont fixés à des états de mouvement extrêmes, en particulier à un instant systolique de fin et/ou diastolique de fin.

10. Procédé suivant l'une des revendications précédentes, dans lequel les instants sont fixés à des instants d'effort moyen afin d'y placer des mesures sensibles à l'effort, en particulier des mesures de diffusion.

11. Procédé suivant l'une des revendications précédentes, dans lequel les instants (170) sont fixés à des instants optimaux pour une préparation de sang noir sensible au mouvement, en particulier à des instants de pente maximum dans le signal de mouvement ou de dérivée de second ordre maximum du signal de mouvement.

12. Procédé suivant l'une des revendications précédentes, dans lequel les instants (180) pour le post-traitement de données sont utilisés pour l'adaptation de la résolution temporelle d'images cinématiques ou cinés rétrogradées, de manière à empêcher une sous-estimation de l'activité cardiaque.

13. Procédé suivant l'une des revendications précédentes, dans lequel les instants (180) de déclenchement ou de post-traitement de données du signal de résonance magnétique acquis sur de multiples battements cardiaques sont fixés suivant des particularités du signal de mouvement ou de ses modèles.

14. Programme d'ordinateur comprenant un code de programme, qui induit un ordinateur (26) à effectuer un procédé suivant l'une quelconque des revendications précédentes, lorsque le code de programme est exécuté sur l'ordinateur.

15. Unité (24) de commande conçue pour effectuer le procédé suivant l'une des revendications 1 à 13.
